# EUROPÄISCHE PATENTSCHRIFT

(11) **EP 1 474 355 B1**
(45) Veröffentlichungstag und Bekanntmachung des Hinweises auf die Patenterteilung: **28.04.2010**
(21) Anmeldenummer: 03739464.0
(22) Anmeldetag: 10.02.2003
(51) Int. Cl.: B81B 3/00, B81B 7/02

(54) **MIKROMECHANISCHES BAUELEMENT UND VERFAHREN ZU DESSEN HERSTELLUNG**
MICROMECHNICAL COMPONENT AND METHOD FOR PRODUCING THE SAME
ELEMENT MICROMECANIQUE ET PROCEDE PERMETTANT DE LE PRODUIRE

(30) Priorität: 11.02.2002 DE 10205585
(43) Veröffentlichungstag der Anmeldung: 10.11.2004
(73) Patentinhaber: Infineon Technologies AG, 85579 Neubiberg (DE)
(72) Erfinder: AIGNER, Robert, 82008 Unterhaching (DE); BRAUER, Michael, 81825 München (DE); BEVER, Thomas, 81827 München (DE); DEHE, Alfons, 85375 Neufahrn (DE); FUELDNER, Marc, 85579 München (DE)
(74) Vertreter: Ginzel, Christian
(86) Internationale Anmeldenummer: PCT/EP2003/001309
(87) Internationale Veröffentlichungsnummer: WO 2003/068668

(56) Entgegenhaltungen:
- US-A- 4 607 383
- US-A- 5 452 268
- US-A- 5 870 482
- US-A- 6 140 689
- US-B1- 6 168 906

## Beschreibung

Die vorliegende Erfindung betrifft mikromechanische Bauelemente und Verfahren zu deren Herstellung. Die vorliegende Erfindung betrifft insbesondere mikromechanische Bauelemente, insbesondere mikromechanische Sensoren, die zumindest eine mikromechanische Membran aufweisen.

Mikromechanische Bauelemente werden beispielsweise als Mikrofon, Drucksensoren oder Beschleunigungssensoren verwendet. Diese Bauelemente weisen ein Substrat, eine Membran und einen zwischen dem Substrat und der Membran angeordneten Hohlraum auf. Der Hohlraum wird üblicherweise mit Hilfe einer Opferschicht hergestellt, auf welche die Membranschicht aufgebracht wird. Anschließend wird zumindest ein Teil der Opferschicht durch Öffnungen in der Membran oder durch Öffnungen in dem Substrat mit Hilfe einer Ätzung entfernt, so dass eine freistehende Membran erzeugt wird. Dabei ist Siliziumoxid ein typisches Material für die Opferschicht. Typische Membranmaterialien sind Polysilizium und Siliziumnitrid oder Kombinationen aus solchen Schichten.

Zur Erhöhung der mechanischen Empfindlichkeit wird die Membran häufig an ihrem Rand nicht fest eingespannt sondern an Federn aufgehängt. Derartige, an Federn aufgehängte Membranen werden üblicherweise durch Schlitze in der Membranschicht erzeugt. Dabei werden die Form der Schlitze und somit die Form der Federn mit dem Ziel einer möglichst großen Steigerung der Empfindlichkeit des Sensors definiert.

Leider weisen Membranschichten in Abhängigkeit von dem gewählten Abscheideverfahren häufig relativ große Zug- bzw. Druckspannungen auf. Weiterhin stellt sich in der Regel ein sogenannter "Stressgradient" über der Schichtdicke ein. Dies führt je nach Ausgestaltung der Membran zu einer Reihe von Schwierigkeiten.

Bei einer an Federn aufgehängten Membran führt der Stressgradient in der Membranschicht in der Regel zu einer vertikalen Verformung der Membran, d.h. es gibt Bereiche der Membran, insbesondere am Rand der Membran, die nicht in der gewünschten Position verharren. Derartige Verformung sind jedoch aus Gründen von präzise einzuhaltenden Abständen unerwünscht. Beispielsweise führen Randverbiegungen in einem kapazitiven Sensor zu unkontrollierten Abständen der Membran gegenüber einer planaren Gegenelektrode, was sich negativ auf die Empfindlichkeit des Sensors auswirkt.

Zur Vermeidung dieser Schwierigkeiten wurde eine Reihe von Maßnahmen vorgeschlagen. So werden beispielsweise nur solche Schichten verwendet, die keinen oder nur einen sehr geringen Stressgradienten aufweisen. Dazu werden entweder monokristalline, hoch dotierte Schichten oder sogenannte SOI Schichten ("Silicon on Insulator") eingesetzt. Leider können derartige Schichten bisher jedoch nicht kompatibel zu den Prozessschritten eingesetzt werden, die zur Herstellung der übrigen Bauelemente eines Sensors verwendet werden. So müssen beispielsweise die Parameter zur Schichtherstellung derart eingestellt werden, daß der Stressgradient entfernt wird. Dies setzt aber in der Regel extreme Temperungen voraus, die nicht ohne weiteres für integrierte Lösungen eingesetzt werden können.

Gemäß einem weiteren Vorschlag kann dem Stressgradienten durch eine Versteifung der Membran entgegengewirkt werden. Eine derartige Versteifung kann z.B. durch Rillen in der Membran erfolgen. Diese Vorgehensweise hat jedoch den Nachteil, dass die zur Versteifung verwendete Struktur eine starke Topologie erzeugt, die für die Prozessierung, insbesondere bei der Fototechnik, problematisch ist.

Weiterhin wirken sich derartige Versteifungen negativ auf die mechanische Empfindlichkeit des Sensors aus.

Die US 6,168,906 beschreibt ein Verfahren zur mikromechanischen Herstellung einer Membran, die sowohl steife als auch flexible Bereiche aufweist. Dabei sind die flexiblen Bereiche aus einander nicht berührenden Riffeln und die steifen Bereiche aus einander berührenden Riffeln gebildet.

Die US 5,452,268 beschreibt einen akustischen Wandler, der ein perforiertes Glied und eine an dem perforierten Glied mittels Federelementen aufgehängte Membran umfaßt.

Die US 6,140,689 beschreibt einen Drucksensor, der eine Membran aufweist, die über einer perforierten Gegenelektrode angeordnet ist. Dadurch kann bei einer Schwingung der Membran ein Druckausgleich über die in der Elektrode vorhandenen Löcher hergestellt werden.

Der vorliegenden Erfindung liegt daher die Aufgabe zugrunde, ein mikromechanisches Bauelement bereitzustellen, welches die beschriebenen Probleme vermindert bzw. ganz vermeidet. Der vorliegenden Erfindung liegt insbesondere die Aufgabe zugrunde, ein mikromechanisches Bauelement mit einer mikromechanischen Membran bereitzustellen, welche eine geringe, stressbedingte Verformung aufweist und welche kompatibel zu bestehenden Technologien hergestellt werden kann.

Diese Aufgabe wird von dem erfindungsgemäßen mikromechanischen Bauelement gemäß dem unabhängigen Patentanspruch 1 sowie von dem Verfahren zur Herstellung eines mikromechanischen Bauelements gemäß des unabhängigen Patentanspruchs 9 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Das erfindungsgemäße mikromechanische Bauelement besitzt den Vorteil, dass sich bedingt durch die konkave (vertiefte, aus der Sicht der Membran nach innen gewölbte) Ausgestaltung der Randbereiche der Membran ein in der Membranschicht vorhandener Stressgradient nur noch gering auswirken kann. Insbesondere können Verbiegungen der Membran, die herkömmlicherweise von einem Stressgradienten verursacht werden, deutlich reduziert werden.

Wird das erfindungsgemäße mikromechanische Bauelement zur Bestimmung einer physikalische Grösse eingesetzt, so weist das erfindungsgemäße mikromechanische Bauelement eine hohe mechanische Empfindlichkeit auf, da die Membran an Federn aufgehängt ist. Weiterhin erlaubt das erfindungsgemäße mikromechanische Bauelement bei einem gegebenem Stressgradienten in der Membranschicht die Wahl eines relativ geringen Zugstresses, was sich wiederum positiv auf die erzielbare Messgenauigkeit auswirkt. Wird das erfindungsgemäße mikromechanische Bauelement als kapazitiver Sensor eingesetzt, so ergibt sich gegenüber herkömmlichen Sensoren, bedingt durch die geringeren Verbiegungen der Membran, ein vergrößerter Dynamikbereich des Sensors. Dies liegt darin begründet, dass der Bewegungsspielraum der Membran aufgrund der deutlich geringeren Verbiegung nicht so stark eingeschränkt ist, wie dies bei herkömmlichen Sensoren der Fall ist. Auch der Fehler in der Grundkapazität, der sich aufgrund verbogener Randbereiche der Membran ergibt, ist gegenüber herkömmlichen Sensoren deutlich reduziert.

Das erfindungsgemäße mikromechanische Bauelement besitzt darüber hinaus den Vorteil, dass durch die konkave Ausgestaltung der Randbereiche der Membran eine Verringerung der parasitären Kapazität gegenüber dem Substrat bzw. gegenüber der Gegenelektrode erzielt und damit das Ausgangssignal erhöht wird. Dies liegt darin begründet, dass die Fläche der Überlappung von Membran und Substrat an der Aufhängung verringert wird.

In dem erfindungsgemäßen mikromechanischen Bauelements ist die Krümmung der konkaven Randbereiche der Membran so gewählt, dass die Verbiegung der Membran kleiner oder gleich dem 1,5-fachen der Dicke der Membran ist. Dabei ist es insbesondere bevorzugt, wenn die Krümmung der konkaven Randbereiche der Membran so gewählt ist, dass die Verbiegung der Membran kleiner oder gleich 50%, bevorzugt 25%, der Dicke der Membran ist.

Gemäß einer weiteren bevorzugten Ausführungsform des erfindungsgemäßen mikromechanischen Bauelements ist an der der Membran gegenüberliegenden Seite des Hohlraums eine Elektrode vorgesehen. Weiterhin ist es bevorzugt, wenn die Membran zumindest teilweise elektrisch leitend ausgebildet ist. Dementsprechend kann das erfindungsgemäße mikromechanische Bauelement als kapazitiver Sensor eingesetzt werden.

Gemäß einer weiteren bevorzugten Ausführungsform des erfindungsgemäßen mikromechanischen Bauelements ist die Membran an mindestens 3 Federn, bevorzugt mindestens 4 Federn, aufgehängt.

Gemäß einer weiteren bevorzugten Ausführungsform des erfindungsgemäßen mikromechanischen Bauelements sind in der Nähe des Randbereichs der Membran Öffnungen in der Membran vorgesehen. Dabei ist es insbesondere bevorzugt, wenn die Krümmung in den Öffnungen größer als die Krümmung der konkaven Randbereiche der Membran ist.

Gemäß einer weiteren bevorzugten Ausführungsform des erfindungsgemäßen Verfahren wird vor Schritt b) in dem Substrat oder auf dem Substrat eine Elektrode erzeugt. Weiterhin ist es bevorzugt, wenn vor Schritt b) zumindest ein Loch in dem Substrat und ggf. in der Elektrode erzeugt wird.

Gemäß einer weiteren bevorzugten Ausführungsform des erfindungsgemäßen Verfahren werden auf dem Substrat weitere Bauelemente, insbesondere Widerstände und Transistoren, erzeugt. Diese weiteren Bauelemente werden bevorzugt mit einer CMOS-, BiCMOS- oder Bipolar-Technologie hergestellt. Das erfindungsgemäße Verfahren besitzt den Vorteil, dass dabei weitgehend Standardverfahren eingesetzt werden können, ohne dass die Herstellung der Membran negative Auswirkungen auf die anderen Bauelemente nach sich zieht.

Gemäß einer weiteren bevorzugten Ausführungsform des erfindungsgemäßen Verfahren wird in der Rückseite des Substrats zumindest eine Vertiefung erzeugt, die unterhalb der Membran angeordnet ist. Dabei ist es insbesondere bevorzugt, wenn die Vertiefung in der Rückseite des Substrats bis zu dem Loch auf der Vorderseite des Substrats reicht. Weiterhin ist es bevorzugt, wenn die Vertiefung in der Rückseite des Substrats durch eine nasschemische Ätzung erzeugt wird. Wird das erfindungsgemäße mikromechanische Bauelement als Drucksensor (Mikrofon) eingesetzt, so kann der Druck durch die Vertiefung in der Rückseite des Substrats und das Loch zu der Membran geführt werden.

Die Erfindung wird nachfolgend anhand von Figuren der Zeichnung näher dargestellt. Es zeigen:
- Fig. 1: ein mikromechanisches Mikrofon gemäß einer ersten Ausführungsform erfindungsgemäßen mikromechanischen Bauelements,
- Fig. 2: eine Aufsicht auf des mikromechanischen Mikrofons aus Fig. 1,
- Fig. 3: ein mikromechanisches Mikrofon gemäß einer weiteren Ausführungsform erfindungsgemäßen mikromechanischen Bauelements,
- Fig. 4: eine Teilansicht auf die Membran gemäß der ersten Ausführungsform erfindungsgemäßen mikromechanischen Bauelements,
- Fig. 5: eine Teilansicht auf die Membran gemäß einer weiteren Ausführungsform erfindungsgemäßen mikromechanischen Bauelements, und
- Fig. 6: eine Teilansicht auf die Membran gemäß einer weiteren Ausführungsform erfindungsgemäßen mikromechanischen Bauelements.

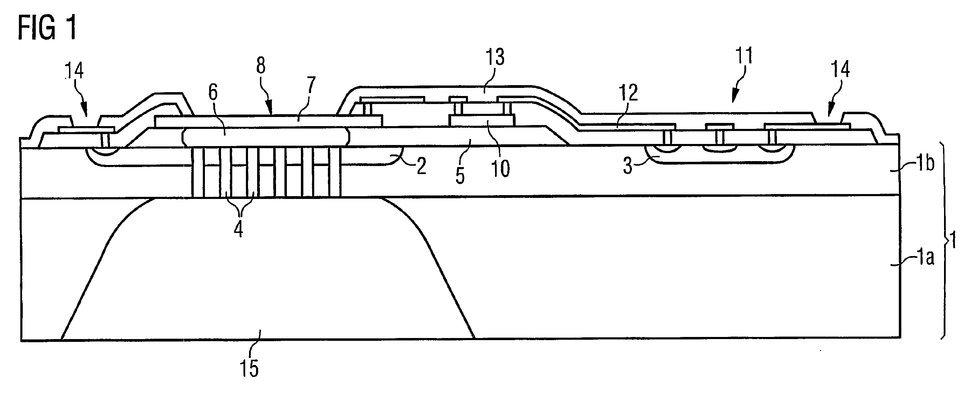

Fig. 1 zeigt ein mikromechanisches Mikrofon gemäß einer ersten Ausführungsform erfindungsgemäßen mikromechanischen Bauelements. Das mikromechanische Mikrofon weist ein Substrat 1 auf, das sich im vorliegenden Beispiel aus einer Siliziumscheibe 1a und einer auf der Siliziumscheibe 1a aufgebracht Silizium-Epitaxieschicht 1b zusammensetzt. Die Dicke der Silizium-Epitaxieschicht 1b beträgt beispielsweise 10 µm. Die Siliziumscheibe 1a und die Silizium-Epitaxieschicht 1b sind im vorliegenden Beispiel n-dotiert.

Durch eine Dotierungstechnik wurden auf der Vorderseite des Substrats p-dotierte Gebiete erzeugt, wobei eines dieser p-dotierten Gebiete als Gegenelektrode 2 zu der Membran 8 verwendet wird. Das andere p-dotierte Gebiet wird als Wanne 3 für eine Transistor (JFET) verwendet. Anschließend wurden in der Vorderseite des Substrates die Löcher 4 erzeugt, die sich von der Vorderseite des Substrats durch die Gegenelektrode 2 und durch die Silizium-Epitaxieschicht 1b bis zu der Siliziumscheibe 1a erstrecken.

Weiterhin wurde auf das Substrat 1 eine Siliziumoxidschicht 5 aufgebracht, die als Opferschicht für die Herstellung des Hohlraums 6 zwischen der Gegenelektrode 3 und der Membran 8 dient. Die Dicke der Siliziumoxidschicht beträgt im vorliegenden Beispiel etwa 1,5 µm. Anschließend wurde auf der Opferschicht 5 eine Membranschicht 7 aufgebracht, die im vorliegenden Beispiel aus p-dotiertem Polysilizium gebildet ist. Die Dicke der Membranschicht 7 beträgt etwa 0,4 µm.

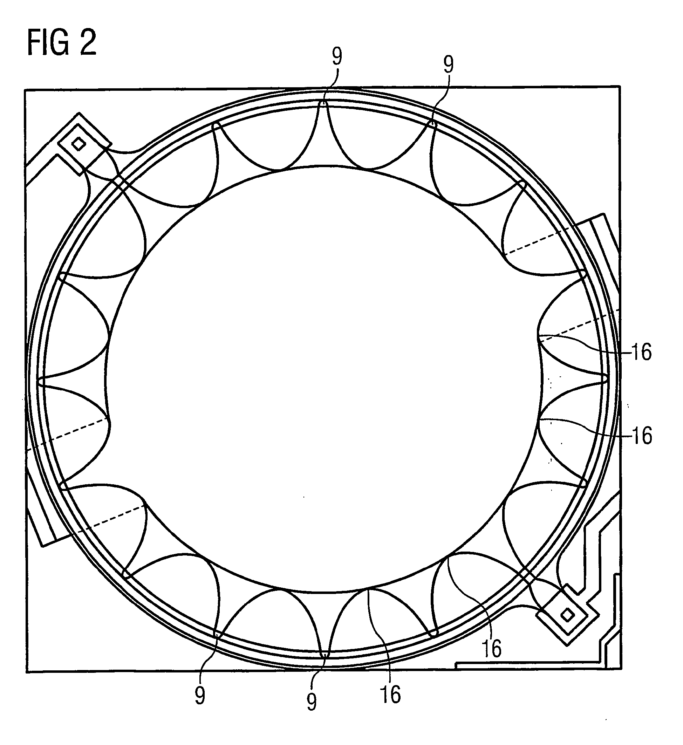

Nachfolgend wurde die Membranschicht 7 mittels einer Phototechnik strukturiert, so dass die Membran 8, die Federn 9 (siehe Fig. 2) sowie ein Widerstand 10 gebildet wurden. Weiterhin wurde mittels herkömmlicher Prozeßschritte eine Transistor 11 (JFET) auf den Substrat 1 gebildet. Anschließend wurde eine Metallisierung 12, im vorliegenden Beispiel eine Goldmetallisierung, sowie eine Passivierung 13 erzeugt. Die Passivierung 13 enthält einige Öffnungen 14, so das die Metallisierung über sogenannte "Pads" von außen kontaktiert werden kann.

Schließlich erfolgte an der Rückseite des Substrats 1 eine naßchemische Ätzung, wodurch eine Vertiefung 15 in der Rückseite des Substrats 1 erzeugt wurde. Die Vertiefung 15 reicht bis zur Silizium-Epitaxieschicht 1b und somit bis zu den Löchern 4. Anschließend erfolgte eine Ätzung der Opferschicht 5, so dass die Opferschicht 5 zumindest teilweise entfernt, ein Hohlraum 6 erzeugt und eine an Federn 9 aufgehängte Membran 8 erzeugt wird, deren Randbereiche 16 zwischen den Federn 9 konkav ausgebildet sind. Dazu wird bevorzugt eine masschemische Ätzung eingesetzt. Es können jedoch auch eine HF-Dampfätzung oder eine Gasphasenätzung eingesetzt werden.

Fig. 2 zeigt eine Aufsicht auf das mikromechanische Mikrofon aus Fig. 1. Man erkennt, dass die Randbereiche 16 der Membran 8 zwischen den Federn 9 konkav ausgebildet sind. Das erfindungsgemäße mikromechanische Mikrofon besitzt den Vorteil, dass sich bedingt durch die konkave (vertiefte, aus der Sicht der Membran nach innen gewölbte) Ausgestaltung der Randbereiche 16 der Membran 8 ein in der Membranschicht 7 vorhandener Stressgradient nur noch gering auswirken kann. Insbesondere können Verbiegungen der Membran 8, die herkömmlicherweise von einem Stressgradienten verursacht werden, deutlich reduziert werden.

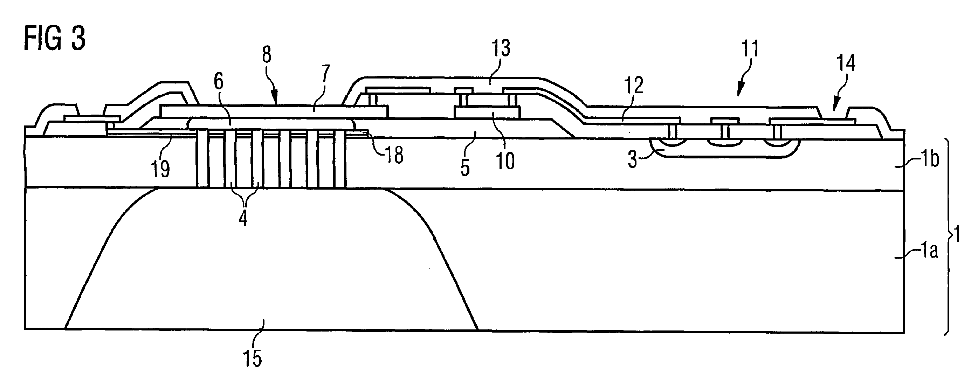

Fig. 3 zeigt ein mikromechanisches Mikrofon gemäß einer weiteren Ausführungsform erfindungsgemäßen mikromechanischen Bauelements. Das in Fig. 3 gezeigte Ausführungsbeispiel entspricht weitgehend dem Ausführungsbeispiel, das bereits im Zusammenhang mit der Fig. 1 beschrieben wurde mit der Ausnahme, dass die Gegenelektrode nunmehr nicht als Dotierungsgebiet in der Epitaxieschicht 1b sondern als leitfähige Schicht 18, beispielsweise dotiertes Polysilizium, ausgebildet ist. Dabei ist die leitfähige Schicht 18 durch dielektrische Schicht, beispielsweise eine Nitridschicht, von der Epitaxieschicht 1b isoliert.

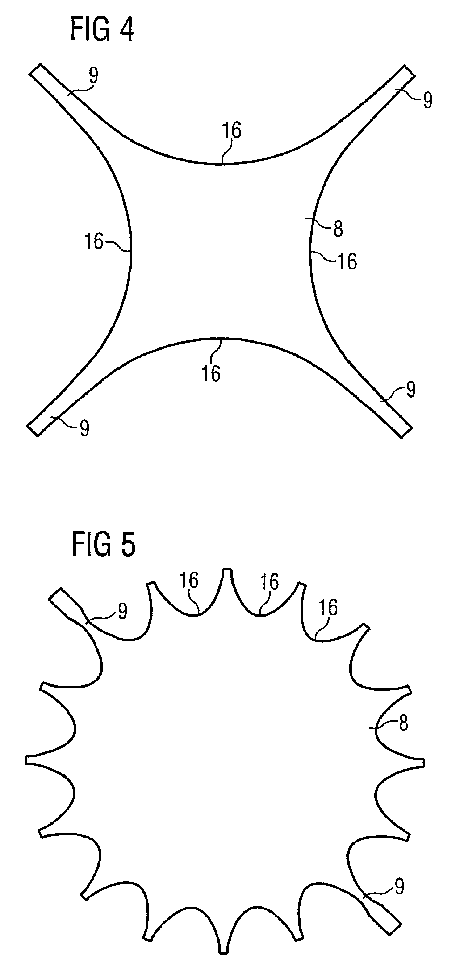

Im Allgemeinen gibt das Verhältnis von Zugstress zu Stressgradient Anhaltspunkte dafür, wie stark die Randbereiche 16 der Membran 8 gekrümmt sein sollten. Zur genauen Analyse ist es dabei hilfreich, FEM-Simulationen (Finite Elemente Method) einzusetzen. Eine FEM-Simulation ergibt für das in der Figur 4 gezeigte Beispiel, bei einem Zugstreß von 50 MPa und einem von Stressgradienten 20 Mpa/µm -eine vertikale Randverbiegung von maximal 600 nm. Die Empfindlichkeit ist (in diesem Beispiel) fünfmal so hoch wie diejenige einer vergleichbaren kreisförmigen Membran.

Die Figur 5 zeigt eine Teilansicht auf die Membran gemäß einer weiteren Ausführungsform erfindungsgemäßen mikromechanischen Bauelements. Die Figur 5 zeigt eine Membran 8, die an 16 Federn 9 aufgehängt ist. Dieses Design ist geeignet für hohe Stressgradienten. Eine FEM-Simulation ergibt, bei einem Zugstreß von 50 MPa und einem Stressgradienten von 20 MPa/µm, eine maximale Randverbiegung von 10O nm. Die Empfindlichkeit ist doppelt so hoch wie diejenige einer vergleichbaren kreisförmigen Membran.

Im diesem Beispiel ist die maximale Randverbiegung nicht größer als 150 nm. Dementsprechend ist die maximale Verbiegung kleiner 10% des Abstands zwischen der Membran 8 und der Elektrode 2 und die durch die Verbiegung bewirkte Kapazitätsänderung ist vernachlässigbar.

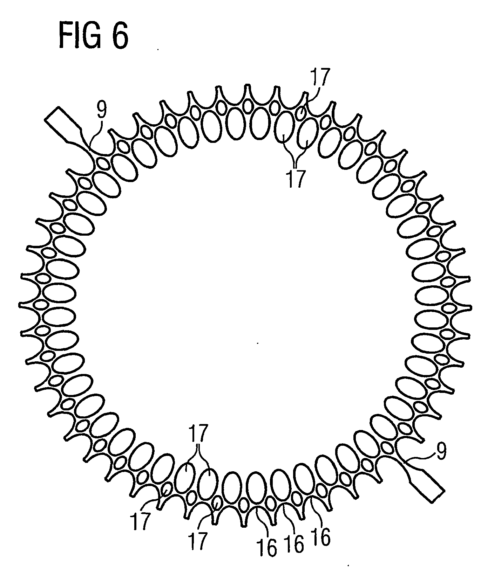

Die Figur 6 zeigt eine Teilansicht auf die Membran 8 gemäß einer weiteren Ausführungsform erfindungsgemäßen mikromechanischen Bauelements. Die Figur 6 zeigt eine Membran 8, die an 48 Federn 9 aufgehängt ist und zwecks Steigerung der Empfindlichkeit noch mit Löchern 17 versehen ist. Dabei ist es insbesondere bevorzugt, wenn die Krümmung in den Öffnungen 17 größer als die Krümmung der konkaven Randbereiche 16 der Membran 8 ist.

Dieses Design ist geeignet für hohe Stressgradienten. Eine FEM-Simulation ergibt, bei einem Zugstress von 50 MPa und einem Stressgradienten von 20 MPa/µm eine maximale Randverbiegung von nur mehr 4Onm. Dabei ist die Empfindlichkeit gleich hoch wie im vorherigen Beispiel.

## Patentansprüche

1. Mikromechanisches Bauelement mit einem Substrat (1), zumindest einer Membran (8) und einem zwischen dem Substrat (1) und der Membran (8) angeordneten Hohlraum (6), wobei die Membran (8) über dem Hohlraum (6) mit Federn (9) aufgehängt ist, wobei die Randbereiche (16) der Membran (8) zwischen den Federn (9) konkav ausgebildet sind,
**dadurch gekennzeichnet, dass**
die Krümmung der konkaven Randbereiche (16) der Membran (8) so gewählt ist, dass die Verbiegung der Membran (8) kleiner oder gleich dem 1,5-fachen der Dicke der Membran (8) ist.

2. Bauelement nach Anspruch 1,
**dadurch gekennzeichnet, daß**
die Krümmung der konkaven Randbereiche (16) der Membran (8) so gewählt ist, dass die Verbiegung der Membran (8) kleiner oder gleich 50%, bevorzugt 25%, der Dicke der Membran (8) ist.

3. Bauelement nach einem der vorhergehenden Ansprüche,
**dadurch gekennzeichnet, daß**
an der der Membran (8) gegenüberliegenden Seite des Hohlraums (6) eine Elektrode (2) vorgesehen ist.

4. Bauelement nach einem der vorhergehenden Ansprüche,
**dadurch gekennzeichnet, daß**
die Membran (8) zumindest teilweise elektrisch leitend ausgebildet ist.

5. Bauelement nach einem der vorhergehenden Ansprüche,
**dadurch gekennzeichnet, daß**
die Membran (8) an mindestens 3 Federn (9), bevorzugt mindestens 4 Federn (9), aufgehängt ist.

6. Bauelement nach einem der vorhergehenden Ansprüche,
**dadurch gekennzeichnet, daß**
in der Nähe des Randbereichs (16) der Membran (8) Öffnungen in der Membran (8) vorgesehen sind.

7. Bauelement nach Anspruch 6,
**dadurch gekennzeichnet, daß**
die Krümmung in den Öffnungen größer als die Krümmung der konkaven Randbereiche (16) der Membran (8) ist.

8. Bauelement nach einem der vorhergehenden Ansprüche,
**dadurch gekennzeichnet, daß**
die Membran (8) dotiertes Polysilizium aufweist.

9. Verfahren zur Herstellung eines mikromechanischen Bauelements, mit den Schritten:
a) ein Substrat (1) wird bereitgestellt,
b) auf dem Substrat (1) wird eine Opferschicht (5) erzeugt,
c) auf der Opferschicht (5) wird eine Membranschicht (7) erzeugt
d) die Membranschicht (7) wird strukturiert, und
e) die Opferschicht (5) wird zumindest teilweise entfernt, so dass eine an Federn (9) aufgehängte Membran (8) erzeugt wird, deren Randbereiche (16) zwischen den Federn (9) konkav ausgebildet sind, wobei die Krümmung der konkaven Randbereiche (16) der Membran (8) so gewählt wird, dass die Verbiegung der Membran (8) kleiner oder gleich dem 1,5-fachen der Dicke der Membran (8) ist.

10. Verfahren nach Anspruch 9,
**dadurch gekennzeichnet, daß**
vor Schritt b) in dem Substrat (1) oder auf dem Substrat (1) eine Elektrode (2) erzeugt wird.

11. Verfahren nach Anspruch 9 oder 10,
**dadurch gekennzeichnet, daß**
vor Schritt b) zumindest ein Loch (4) in dem Substrat (1) und ggf. in der Elektrode (2) erzeugt wird.

12. Verfahren nach einem der Ansprüche 9 bis 11,
**dadurch gekennzeichnet, daß**
auf dem Substrat (1) weitere Bauelemente (10, 11), insbesondere Widerstände und Transistoren, erzeugt werden.

13. Verfahren nach einem der Ansprüche 9 bis 12,
**dadurch gekennzeichnet, daß**
in der Rückseite des Substrats (1) zumindest eine Vertiefung (15) erzeugt wird.

14. Verfahren nach Anspruch 13,
**dadurch gekennzeichnet, daß**
die Vertiefung (15) in der Rückseite des Substrats (1) bis zu dem Loch (4) reicht.

15. Verfahren nach Anspruch 13 oder 14,
**dadurch gekennzeichnet, daß**
die Vertiefung (15) in der Rückseite des Substrats (1) durch eine nasschemische Ätzung erzeugt wird.

## Claims

1. Micromechanical component comprising a substrate (1), at least one membrane (8) and a cavity (6) arranged between the substrate (1) and the membrane (8), the membrane (8) being suspended above the cavity (6) by means of springs (9), the edge regions (16) of the membrane (8) being formed in concave fashion between the springs (9),
**characterized in that**
the curvature of the concave edge regions (16) of the membrane (8) is chosen such that the bending of the membrane (8) is less than or equal to 1.5 times the thickness of the membrane (8).

2. Component according to Claim 1,
**characterized in that**
the curvature of the concave edge regions (16) of the membrane (8) is chosen such that the bending of the membrane (8) is less than or equal to 50%, preferably 25%, of the thickness of the membrane (8).

3. Component according to any of the preceding claims,
**characterized in that**
an electrode (2) is provided at that side of the cavity (6) which lies opposite the membrane (8).

4. Component according to any of the preceding claims,
**characterized in that**
the membrane (8) is embodied such that it is at least partly electrically conductive.

5. Component according to any of the preceding claims,
**characterized in that**
the membrane (8) is suspended from at least three springs (9), preferably at least four springs (9).

6. Component according to any of the preceding claims,
**characterized in that**
openings are provided in the membrane (8) in the vicinity of the edge region (16) of the membrane (8).

7. Component according to Claim 6,
**characterized in that**
the curvature in the openings is greater than the curvature of the concave edge regions (16) of the membrane (8).

8. Component according to any of the preceding claims,
**characterized in that**
the membrane (8) comprises doped polysilicon.

9. Method for producing a micromechanical component, comprising the following steps:
a) a substrate (1) is provided,
b) a sacrificial layer (5) is produced on the substrate (1),
c) a membrane layer (7) is produced on the sacrificial layer (5),
d) the membrane layer (7) is structured, and
e) the sacrificial layer (5) is at least partly removed, such that a membrane (8) suspended from springs (9) is produced, the edge regions (16) of which membrane are formed in concave fashion between the springs (9), the curvature of the concave edge regions (16) of the membrane (8) being chosen such that the bending of the membrane (8) is less than or equal to 1.5 times the thickness of the membrane (8).

10. Method according to Claim 9,
**characterized in that**
before step b), an electrode (2) is produced in the substrate (1) or on the substrate (1).

11. Method according to Claim 9 or 10,
**characterized in that**
before step b), at least one hole (4) is produced in the substrate (1) and, if appropriate, in the electrode (2).

12. Method according to any of Claims 9 to 11,
**characterized in that**
further components (10, 11), in particular resistors and transistors, are produced on the substrate (1).

13. Method according to any of Claims 9 to 12,
**characterized in that**
at least one depression (15) is produced in the rear side of the substrate (1).

14. Method according to Claim 13,
**characterized in that**
the depression (15) in the rear side of the substrate (1) reaches as far as the hole (4).

15. Method according to Claim 13 or 14,
**characterized in that**
the depression (15) in the rear side of the substrate (1) is produced by means of a wet-chemical etch.

## Revendications

1. Elément micromécanique comprenant un substrat (1), au moins une membrane (8) et une cavité (6), disposée entre le substrat (1) et la membrane (8), la membrane (8) étant suspendue au-dessus de la cavité (6) par des ressorts (9), les parties (16) marginales de la membrane étant concaves entre les ressorts (9),
**caractérisé en ce que**
la courbure des parties (16) marginales concaves de la membrane (8) est choisie de manière à ce que la flexion de la membrane (8) soit inférieure ou égale à 1,5 fois l'épaisseur de la membrane (8).

2. Elément suivant la revendication 1,
**caractérisé en ce que**
la courbure des parties (16) marginales concaves de la membrane (8) est choisie de manière à ce que la flexion de la membrane (8) soit inférieure ou égale à 50 %, de préférence à 25 %, de l'épaisseur de la membrane (8).

3. Elément suivant l'une des revendications précédentes,
**caractérisé en ce que**
**en ce qu'**il est prévu une électrode (2) du côté de la cavité (6) opposé à la membrane (8).

4. Elément suivant l'une des revendications précédentes,
**caractérisé en ce que**
la membrane (8) est constituée, au moins en partie, d'une manière conductrice de l'électricité.

5. Elément suivant l'une des revendications précédentes,
**caractérisé en ce que**
la membrane (8) est suspendue par au moins 3 ressorts (9), de préférence 4 ressorts (9).

6. Elément suivant l'une des revendications précédentes,
**caractérisé en ce que**
il est prévu des ouvertures dans la membrane (8) à proximité de la partie (16) marginale de la membrane (8).

7. Elément suivant la revendication 6,
**caractérisé en ce que**
la courbure dans les ouvertures est plus grande que la courbure des parties (16) marginales concaves de la membrane (8).

8. Elément suivant l'une des revendications précédentes,
**caractérisé en ce que**
la membrane (8) comporte du polysilicium dopé.

9. Procédé de fabrication d'un élément micromécanique, comprenant les stades dans lesquels :
a) on se procure un substrat (1),
b) on produit une couche (5) sacrificielle sur le substrat (1),
c) on produit une couche (7) formant membrane sur la couche (5) sacrificielle,
d) on structure la couche (7) formant membrane, et
e) on élimine au moins en partie la couche (5) sacrificielle de manière à produire une membrane (8) suspendue par des ressorts (9) dont les parties (16) marginales entre les ressorts (9) sont concaves, la courbure des parties (16) marginales concaves de la membrane (8) étant choisie de façon à ce que la flexion de la membrane (8) soit inférieure ou égale à 1,5 fois l'épaisseur de la membrane (8).

10. Procédé suivant la revendication 9,
**caractérisé en ce que**
avant le stade b), on produit une électrode (2) dans le substrat (1) ou sur le substrat (1).

11. Procédé suivant la revendication 9 ou 10,
**caractérisé en ce que**
avant le stade b), on produit au moins un trou (4) dans le substrat (1) et, le cas échéant, dans l'électrode (2).

12. Procédé suivant l'une des revendications 9 à 11,
**caractérisé en ce que**
l'on produit sur le substrat (1) d'autres composants (10, 11), notamment des résistances et des transistors.

13. Procédé suivant l'une des revendications 9 à 12,
**caractérisé en ce que**
l'on produit au moins une cavité (15) dans la face arrière du substrat (1).

14. Procédé suivant la revendication 13,
**caractérisé en ce que**
la cavité (15) dans la face arrière du substrat (1) va jusqu'au trou (4).

15. Procédé suivant la revendication 13 ou 14,
**caractérisé en ce que**
l'on produit la cavité (15) dans la face arrière du substrat (1) par une attaque chimique en voie humide.
